# FASCICULE DE BREVET EUROPEEN

(11) **EP 2 773 043 B1**
(45) Date de publication et mention de la délivrance du brevet: **21.09.2016**
(21) Numéro de dépôt: 14156715.6
(22) Date de dépôt: 26.02.2014
(51) Int. Cl.: H03K 17/96

(54) **Systeme de detection de toucher par effet capacitif pour dispositif electronique**
Berührungsdetektionssystem durch kapazitiven Effekt für elektronische Vorrichtung
Capacitive touch-detection system for electronic device

(30) Priorité: 28.02.2013 FR 1351812
(43) Date de publication de la demande: 03.09.2014
(73) Titulaire: Atlantic Industrie, 85000 La Roche sur Yon (FR)
(72) Inventeur: BONY, Yves, 85170 DOMPIERRE SUR YON (FR); COUGNAUD, Mathieu, 85000 La Roche-sur-Yon (FR); GOEURY, Sébastien, 85600 BOUFFERE (FR)
(74) Mandataire: Cabinet Chaillot

(56) Documents cités:
- EP-A1- 0 780 865
- EP-A1- 0 859 467
- EP-A2- 1 030 536
- EP-A2- 1 416 636
- EP-A2- 1 672 797
- DE-U1- 20 119 700
- FR-A1- 2 358 787

## Description

L'invention concerne un système de détection de toucher par effet capacitif pour dispositif électronique et, plus particulièrement, un tel système dans lequel les influences électromagnétiques entre des touches adjacentes sont limitées.

Un système électronique dont les paramètres de fonctionnement sont modifiés par intervention physique de l'utilisateur comporte de manière générale une ou plusieurs cartes électroniques commandant le fonctionnement de ce système électronique. Pour une utilisation conviviale d'un tel système électronique et pour des raisons de sécurité, la ou les cartes électroniques du système ne sont pas directement accessibles par l'utilisateur et sont protégées dans un boîtier. L'utilisateur interagit alors avec la ou les cartes électroniques du système électronique par l'intermédiaire d'un panneau de commande, souvent en face avant dudit boîtier (le panneau de commande est alors la face avant), faisant office d'interface homme-machine (IHM) entre le système électronique et l'utilisateur.

Il est alors nécessaire de détecter et de transmettre une information de l'utilisateur depuis ledit panneau de commande jusqu'à la(aux) carte(s) électronique(s).

Il existe à l'heure actuelle plusieurs types d'interface entre un panneau de commande isolant et une carte électronique.

Certaines sont mécaniques, d'autres tactiles. On s'intéresse en particulier aux interfaces utilisées dans le cadre de procédés de détection sensitive d'appui, par exemple par effet capacitif, permettant de rattraper la hauteur entre le panneau de commande isolant et la carte électronique.

Un premier type d'interface est constitué par les ressorts de type Philipp Spring ®, placés entre une carte électronique et une touche de commande, et qui sont des ressorts comportant une première partie d'extrémité de fixation à la carte électronique, une partie cylindrique centrale et une deuxième partie d'extrémité conique s'évasant de la partie centrale du ressort vers l'autre extrémité destinée à entrer en contact avec la touche, cette deuxième partie étant destinée, lorsque le ressort est comprimé avec sa deuxième partie comprimée, à former un disque de contact contre la touche pour détecter plus facilement une action sur la touche. Le ressort permet une transmission électrique du panneau de commande à la carte électronique, tout en absorbant dans une certaine mesure les tolérances mécaniques d'assemblage.

Ce premier type d'interface présente cependant deux inconvénients. Premièrement, la sensibilité est faible car la zone active est un fil, et non une surface. Même lorsque la surface conique du ressort est comprimée, la surface en contact avec la face interne de la face avant est faible. De plus, en cas de forte intégration des touches sur le panneau de commande, on constate une influence des touches les unes sur les autres. En effet, la carte électronique génère un signal sur chacune des touches afin d'y détecter un éventuel appui. Une manifestation de l'influence des touches les unes sur les autres est la présence, sur les touches adjacentes, d'un signal résiduel créé par « transmission » du signal utilisé sur une touche pour y détecter un appui, ce qui implique un bruit (c'est-à-dire un signal non utile) sur les touches adjacentes, donc un rapport signal utile sur bruit dégradé, ce qui se traduit globalement par une perte de sensibilité de détection pour chacune des touches et/ou une probabilité de fausse détection non nulle.

Un deuxième type d'interface est constitué par une pièce en forme de Z, faisant l'objet du dispositif à touche sensitive de la demande de brevet européen EP0780865A1. Cette pièce en forme de Z et conductrice de l'électricité est placée entre la carte électronique et un panneau de commande de type verre ou vitrocéramique. Un toucher de l'utilisateur sur le panneau en verre ou vitrocéramique est détecté par effet capacitif sur la pièce en forme de Z, et transmis à la carte électronique par la pièce en forme de Z. La pièce en forme de Z permet une transmission électrique du panneau de commande à la carte électronique, tout en absorbant les tolérances mécaniques d'assemblage.

Ce deuxième type d'interface nécessite cependant que la surface du panneau de commande (face avant) en contact avec la touche Z soit plane, sinon le contact avec la partie supérieure de la touche en forme de Z, également plane, est réduit et en conséquence la sensibilité de détection de la touche correspondante est réduite. Comme pour l'autre état antérieur de la technique décrit, du fait que la touche en forme de Z est métallique, une forte intégration génère des influences entre les touches et contribue donc également à diminuer la sensibilité de détection de chaque touche. De même, un signal résiduel est créé, sur les touches adjacentes, par « transmission » du signal utilisé sur une touche pour y détecter un appui, ce qui se traduit globalement par une perte de sensibilité de détection pour chacune des touches et/ou une probabilité de fausse détection non nulle.

On peut noter également que la touche Z ne permet de récupérer efficacement les tolérances mécaniques que selon l'axe vertical.

Il existe également la mousse conductrice, par exemple celle faisant l'objet de la demande de brevet européen EP0859467. La mousse présente une conductivité électrique dans certains cas suffisante, son caractère élastique permet d'absorber efficacement les tolérances d'assemblage et de s'affranchir de la planéité de la surface du panneau de commande en contact avec la mousse.

Cependant, ce type de mousse conductrice présente, comme pour les deux autres états de la technique exposés plus haut, l'inconvénient d'une diminution de la sensibilité de détection de chaque touche individuelle en cas de forte intégration de touches. De même, un signal résiduel est créé, sur les touches adjacentes, par « transmission » du signal utilisé sur une touche pour y détecter un appui, ce qui se traduit globalement par une perte de sensibilité de détection pour chacune des touches et/ou une probabilité de fausse détection non nulle.

Les demandes de brevets EP 2 597 774 A1, au nom de la demanderesse, DE 201 19 700 U1, EP 1 030 536 A2 et EP 1 416 636 A2 décrivent également des systèmes de détection de toucher selon l'état antérieur de la technique.

Il est donc nécessaire d'obtenir une interface mécanique conductrice qui surmonte les inconvénients de l'état antérieur de la technique, c'est-à-dire une interface mécanique conductrice présentant une bonne conductivité électrique, rattrapant la hauteur entre le panneau de commande isolant et la carte électronique, permettant d'absorber les tolérances mécaniques d'assemblage entre ceux-ci, ne détériorant pas la sensibilité de détection de chaque touche en cas de forte intégration de touches et rendant minimaux les signaux résiduels créés par transmission, depuis chaque touche adjacente, de chaque signal utile à chacune de ces touches adjacentes pour y détecter un appui.

La solution proposée par la présente invention est une pièce permettant une conduction électrique entre la surface du panneau de commande destinée à être en contact avec la pièce et la carte électronique (ou un circuit imprimé sur la carte électronique) par un moyen de conduction électrique offrant le minimum de surface de conduction électrique en regard des surfaces de conduction électrique des moyens de conduction électrique similaires des pièces adjacentes et/ou autre(s) partie(s) conductrice(s).

L'invention vise à proposer une interface mécanique conductrice de structure simple, facile à fabriquer et à incorporer dans un système électronique dont les paramètres de fonctionnement sont modifiés par intervention physique de l'utilisateur sur un panneau de commande de ce système. En outre, la sensibilité de détection de chaque touche du panneau de commande est améliorée par optimisation du procédé de transmission de charges entre les touches du panneau de commande du système électronique et la carte électronique de ce système électronique par diminution des influences des touches entre elles. Par voie de conséquence, la diminution des influences des touches entre elles implique que le signal utile de détection d'appui de chaque touche est moins perturbé par les autres touches du système, donc que le rapport signal utile sur bruit de chacune des touches est augmenté, donc que le fonctionnement de la détection d'appui est plus robuste et moins sujet à de fausses détections.

Les pièces envisagées selon la présente invention sont tridimensionnelles, puisqu'elles rattrapent la hauteur entre la carte électronique et le panneau de commande isolant et qu'elles absorbent les tolérances d'assemblage mécaniques entre ceux-ci.

Les pièces permettant d'atteindre l'objectif de l'invention ne peuvent donc pas avoir une conductivité uniforme dans les trois dimensions, type mousse conductrice, sauf à retrouver les inconvénients de l'état antérieur de la technique.

Les pièces selon l'invention présentent donc, dans leur partie la plus en contact avec les autres pièces, c'est-à-dire la partie située entre le panneau de commande isolant et la carte électronique, une conductivité surfacique pour rendre minimales les influences des différentes pièces entre elles en cas de forte intégration de pièces.

Cependant, pour garder une bonne sensibilité de détection au niveau du panneau et une bonne transmission au niveau de la carte électronique, les pièces de l'invention ont une surface de contact maximale avec ces deux éléments.

La présente invention a donc pour objet un système de détection de toucher par effet capacitif pour dispositif électronique, comprenant un panneau de commande isolant présentant au moins deux zones de détection de toucher, une carte électronique commandée par le panneau de commande isolant et commandant le dispositif électronique, la carte électronique présentant au moins deux zones conductrices de mesure dont la variation de capacité est mesurée par ladite carte électronique, le panneau de commande isolant et la carte électronique étant montés espacés et sensiblement parallèles de telle sorte que chaque zone de détection de toucher du panneau de commande isolant est au droit d'une zone conductrice de mesure, le système de détection de toucher comprenant en outre une pièce d'interface conductrice entre chaque zone de détection de toucher et la zone conductrice de mesure correspondante située au droit de celle-ci, chaque pièce d'interface conductrice étant un corps présentant une surface conductrice supérieure en contact avec la zone de détection de toucher, une surface conductrice inférieure en contact avec la zone conductrice de mesure, et un élément conducteur de l'électricité s'étendant entre les surfaces conductrices supérieure et inférieure pour assurer une conduction électrique entre celles-ci, caractérisé par le fait que la pièce d'interface conductrice présente en outre au moins une surface non conductrice s'étendant entre les surfaces conductrices supérieure et inférieure, l'élément conducteur étant constitué par deux surfaces intermédiaires conductrices planes parallèles entre elles et orthogonales aux plans du panneau de commande isolant et de la carte électronique et reliant de manière conductrice la surface conductrice supérieure et la surface conductrice inférieure, les surfaces conductrices supérieure et inférieure étant situées entre les deux surfaces conductrices intermédiaires de telle sorte que la pièce d'interface conductrice a sensiblement un profil de forme rectangulaire en coupe transversale.

Le panneau de commande isolant est avantageusement en matière plastique, verre ou vitrocéramique.

On appelle zone de détection de toucher du panneau de commande isolant chaque zone, repérée ou non sur la surface externe du panneau de commande isolant sur laquelle l'utilisateur exécute une action de toucher. Ainsi, lorsqu'il est indiqué dans la présente demande qu'une pièce d'interface conductrice est en contact avec la zone de détection de toucher, cela signifie que la pièce d'interface conductrice est en contact avec la partie de la surface du panneau de commande isolant tournée vers la carte électronique qui est au droit de la zone de détection de toucher de la surface opposée du panneau de commande isolant.

Ainsi, selon l'invention, la pièce d'interface conductrice a une surface de contact maximale avec d'une part le panneau de commande isolant, pour augmenter la surface et donc la sensibilité de détection de toucher, et d'autre part avec la carte électronique, pour favoriser la transmission de détection de toucher à la carte électronique, tout en ayant au moins une surface non conductrice entre les surfaces conductrices supérieure et inférieure pour offrir le minimum de surface conductrice en regard d'une pièce d'interface conductrice adjacente.

Selon un mode de réalisation, les surfaces non conductrices sont constituées par les surfaces externes vides entre les surfaces conductrices supérieure, inférieure et intermédiaires.

Selon un autre mode de réalisation, la pièce d'interface conductrice comporte en outre une mousse électriquement isolante occupant l'espace entre les quatre faces conductrices, les faces externes de la mousse électriquement isolante orthogonales aux surfaces intermédiaires conductrices constituant deux surfaces non conductrices.

Les surfaces conductrices peuvent être en tresse métallique. La souplesse de la tresse métallique, associée ou non à une mousse isolante, permet d'assurer la fonction de rattrapage de hauteur entre le panneau de commande et la carte électronique.

La mousse électriquement isolante est avantageusement en uréthane.

Selon une caractéristique particulière de l'invention, les surfaces conductrices intermédiaires de deux pièces d'interface conductrices adjacentes sont orthogonales.

On limite ainsi les interférences électromagnétiques entre deux pièces d'interface conductrices adjacentes.

L'invention présente de nombreux intérêts, parmi lesquels :
- pas de récupération de charge sur une touche lors d'un appui sur une touche adjacente, ce qui permet d'avoir un niveau détecté quasi nul sur une touche lors d'un appui sur une touche adjacente ;
- pas de fuite de charge vers une touche adjacente lors d'un appui sur une touche, ce qui permet une meilleure sensibilité ;
- meilleure distinction entre appui et absence d'appui sur une touche ;
- meilleure immunité à la compatibilité électromagnétique ;
- moins de fausses détections ;
- du fait de la meilleure détection, les besoins logiciels de traitement de détection de toucher sont moindres, ce qui permet d'obtenir une meilleure réactivité et moins de risques de bogue ;
- la forte diminution de l'influence entre des touches tactiles adjacentes permet une plus grande intégration de touches tactiles et donc plus de possibilités de conception ;
- la meilleure sensibilité de détection permet également d'avoir une épaisseur de panneau de commande isolant plus importante ;
- le rattrapage de hauteur opéré par la pièce d'interface conductrice tridimensionnelle entre le panneau de commande isolant et la carte électronique permet en outre une meilleure fiabilité et de ne pas avoir de bulles d'air en façade.

Pour mieux illustrer l'objet de la présente invention, on va en décrire ci-après des modes de réalisation, avec référence aux dessins annexés.

Sur ces dessins :
- les Figures 1A-1B sont des vues en perspective d'une pièce d'interface conductrice selon deux modes de réalisation de l'invention ;
- la Figure 2 est une vue en perspective d'un système de détection de toucher selon l'invention ; et
- la Figure 3 est une vue schématique de dessus de la disposition des pièces d'interface conductrices qui limite les influences des touches entre elles dans un système de détection de toucher selon l'invention.

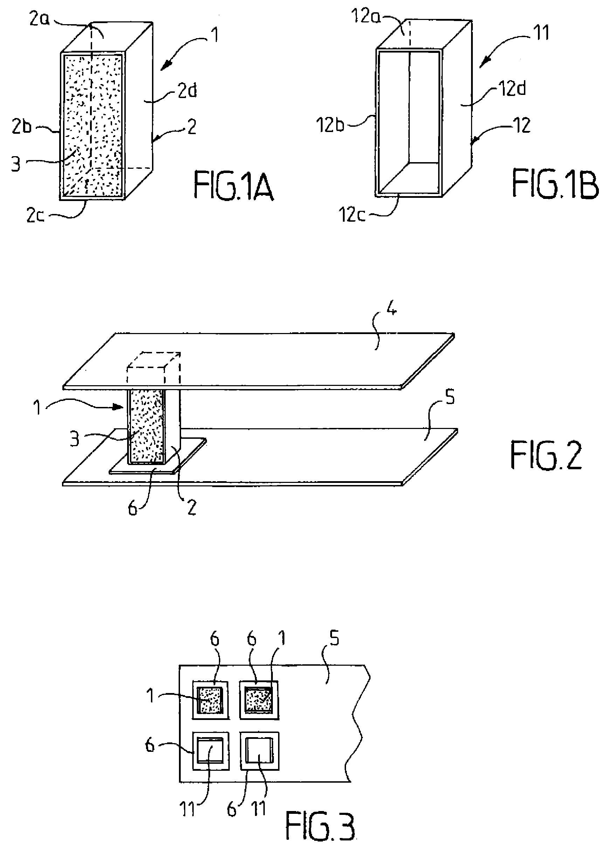

Si l'on se réfère à la Figure 1A, on peut voir que l'on y a représenté une pièce d'interface conductrice 1 pour système de détection de toucher selon un premier mode de réalisation de l'invention.

La pièce d'interface conductrice 1 a la forme d'un corps parallélépipédique rectangle creux, avec une surface conductrice 2 ayant quatre faces 2a, 2b, 2c, 2d reliées entre elles, opposées et parallèles deux à deux, qui sont conductrices et constituent quatre des faces externes de la pièce d'interface conductrice 1. Dans le mode de réalisation représenté, les faces conductrices 2a, 2b, 2c, 2d sont en tresse métallique.

Une mousse électriquement isolante 3, également de forme parallélépipédique rectangle, occupe l'intérieur de la pièce d'interface conductrice 1, deux faces externes opposées de la mousse électriquement isolante 3 constituant les deux dernières faces externes de la pièce d'interface conductrice 1.

Si l'on se réfère à la Figure 1B, on peut voir que l'on y a représenté une pièce d'interface conductrice 11 pour système de détection de toucher selon un deuxième mode de réalisation de l'invention.

La pièce d'interface conductrice 11 a la forme d'un corps parallélépipédique rectangle creux, avec une surface conductrice 12 ayant quatre faces 12a, 12b, 12c, 12d reliées entre elles, opposées et parallèles deux à deux, qui sont conductrices et constituent quatre des faces externes de la pièce d'interface conductrice 11. Dans le mode de réalisation représenté, les faces conductrices 12a, 12b, 12c, 12d sont en tresse métallique.

Deux des faces de la pièce d'interface conductrice 11 sont ouvertes, de telle sorte que la pièce d'interface conductrice 11 a sensiblement une forme rectangulaire (en O) en coupe transversale.

Si l'on se réfère à la Figure 2, on peut voir que l'on y a représenté, à titre illustratif et non limitatif, une pièce d'interface conductrice 1 selon le premier mode de réalisation de l'invention, en position d'utilisation dans un dispositif électronique à fonction tactile, comprenant un panneau de commande isolant 4, sur lequel l'utilisateur effectue une action de toucher, et une carte électronique 5, parallèle au panneau de commande isolant 4, et comprenant, pour chaque pièce d'interface conductrice 1, une zone conductrice de mesure 6 destinée à détecter un changement de potentiel sur la surface conductrice 2 de la pièce d'interface conductrice 1, afin de détecter un toucher et d'effectuer une action correspondant au toucher par envoi d'un signal aux autres éléments électroniques (non représentés) sur la carte électronique 5.

Dans le dispositif électronique à fonction tactile, chaque pièce d'interface conductrice 1 correspond à une touche ou zone tactile qui est, sur la surface externe du panneau de commande isolant 4 sur laquelle l'utilisateur effectue une action de toucher, l'aire en regard de la surface conductrice supérieure 2a de la pièce d'interface conductrice 1.

La pièce d'interface conductrice 1 a pour fonction principale de transmettre un toucher effectué par un utilisateur sur la surface externe du panneau de commande isolant 4 à la zone conductrice de mesure 6. La carte électronique 5 mesure les variations de capacité de chaque zone conductrice de mesure 6 pour détecter un toucher.

Un toucher sur la surface externe du panneau de commande isolant 4 va en effet, par effet capacitif, induire un changement de potentiel sur la surface conductrice 2a de la pièce d'interface conductrice 1, qui va se propager sur toute la surface conductrice 2 de la pièce d'interface conductrice 1 pour être détecté finalement sur la zone conductrice de mesure 6. La pièce d'interface conductrice 1 a également une fonction de rattrapage de hauteur entre la carte électronique 5 et le panneau de commande isolant 4, permettant d'assurer que les deux surfaces conductrices 2a et 2c de la pièce d'interface conductrice 1 sont toujours en contact respectivement avec la face interne du panneau de commande isolant 4 tournée vers la carte électronique 5 et la zone conductrice de mesure 6, pour assurer une bonne détection de toucher sur le panneau de commande isolant 4 et une bonne transmission du changement de potentiel sur la surface conductrice 2 à la zone conductrice de mesure 6.

Bien que cela ne soit pas représenté pour la pièce d'interface conductrice 11, celle-ci a également les mêmes fonctions de transmission d'un changement de potentiel provoqué par un toucher sur le panneau de commande isolant 4 et de rattrapage de hauteur entre le panneau de commande isolant 4 et la carte électronique 5. La pièce d'interface conductrice 11 peut être utilisée de la même manière que celle indiquée pour la pièce d'interface conductrice 1 sur la Figure 2.

La Figure 3 indique les placements des pièces d'interface conductrices 1 et 11 selon respectivement les premier et deuxième modes de réalisation de l'invention, lorsque plusieurs touches tactiles adjacentes sont prévues sur le dispositif électronique.

Sur la Figure 3, on a représenté une vue en coupe de dessus de la disposition sur les zones conductrices de mesure 6 de la carte électronique 5 de plusieurs pièces d'interface conductrices 1 et 11 selon les premier et deuxième mode de réalisation, lorsqu'il y a plusieurs touches tactiles présentes sur le dispositif tactile.

Ainsi, sur la première ligne de la Figure 3, on a représenté deux pièces d'interface conductrices 1 selon le premier mode de réalisation de l'invention, disposées adjacentes de telle sorte que les faces 2b et 2d d'une pièce d'interface conductrice 1 soient orthogonales aux faces 2b et 2d de l'autre pièce d'interface conductrice 1.

Ainsi, les faces conductrices situées dans un plan orthogonal aux plans du panneau de commande isolant 4 et de la carte électronique 5 sont décalées de 90° pour deux pièces d'interface conductrices 1 adjacentes, de telle sorte qu'une face conductrice 2b ou 2d d'une pièce d'interface conductrice 1 est en face d'une face non conductrice 3 de la pièce d'interface conductrice 1 adjacente. On limite ainsi les interférences électromagnétiques possibles entre deux pièces d'interface conductrices 1 adjacentes.

On a représenté, sur la Figure 3, dans un but de simplification, les deux pièces d'interface conductrices 1 du premier mode de réalisation sur une ligne. La disposition serait la même pour deux pièces d'interface conductrices 1 sur une colonne, le principe étant qu'une face conductrice selon un plan orthogonal aux plans du panneau de commande isolant 4 et de la carte électronique 5 d'une pièce d'interface conductrice 1 soit en face d'une face non conductrice 3 d'une pièce d'interface conductrice 1 adjacente. Ainsi, si l'on a plusieurs lignes et colonnes de touches, donc plusieurs lignes et colonnes de pièces d'interface conductrices 1, alors deux pièces d'interface conductrices 1 adjacentes, sur une ligne ou une colonne, sont décalées comme indiqué ci-dessus, ceci dans le but de limiter les interférences électromagnétiques entre deux pièces d'interface conductrices 1 adjacentes, et donc d'augmenter la détection de toucher sur une touche tactile du panneau de commande isolant 4.

Sur la deuxième ligne de la Figure 3, on a représenté la disposition de deux pièces d'interface conductrices adjacentes 11 selon le deuxième mode de réalisation de l'invention.

Comme pour le premier mode de réalisation, celles-ci sont décalées de 90° de telle sorte qu'une face conductrice 12b ou 12d d'une pièce d'interface conductrice 11 soit en face d'une face vide d'une pièce d'interface conductrice 11 adjacente. La disposition serait la même pour deux pièces d'interface conductrices 11 sur une colonne, le principe étant qu'une face conductrice selon un plan orthogonal aux plans du panneau de commande isolant 4 et de la carte électronique 5 d'une pièce d'interface conductrice 11 soit en regard d'une face non conductrice d'une pièce d'interface conductrice 11 adjacente.

La présente invention comprend également le cas où les surfaces conductrices entre le panneau de commande isolant et la carte électronique des pièces d'interface conductrices des premier et deuxième modes de réalisation sont parallèles lorsque les touches tactiles sont adjacentes sont soit sur une ligne, soit sur une colonne, lorsque la distance entre ladite ligne ou ladite colonne et une ligne ou colonne suivante de touches tactiles est suffisamment grande pour négliger l'influence d'une ligne ou colonne sur la ligne ou colonne adjacente.

Ainsi, dans le cas précité où deux lignes ou deux colonnes sont suffisamment éloignées pour pouvoir négliger l'influence des touches tactiles d'une ligne ou colonne à l'autre, au sein d'une ligne ou d'une colonne, la disposition de deux pièces d'interface conductrices adjacentes des premier et deuxième modes de réalisation avec les surfaces conductrices entre le panneau de commande isolant et la carte électronique parallèles permet de limiter l'influence d'une touche tactile à sa ou ses touches tactiles adjacentes.

## Revendications

1. Système de détection de toucher par effet capacitif pour dispositif électronique, comprenant un panneau de commande isolant (4) présentant au moins deux zones de détection de toucher, une carte électronique (5) commandée par le panneau de commande isolant (4) et commandant le dispositif électronique, la carte électronique (5) présentant au moins deux zones conductrices de mesure (6) dont la variation de capacité est mesurée par ladite carte électronique (5), le panneau de commande isolant (4) et la carte électronique (5) étant montés espacés et sensiblement parallèles de telle sorte que chaque zone de détection de toucher du panneau de commande isolant (4) est au droit d'une zone conductrice de mesure (6), le système de détection de toucher comprenant en outre une pièce d'interface conductrice (1 ; 11) entre chaque zone de détection de toucher et la zone conductrice de mesure (6) correspondante située au droit de celle-ci, chaque pièce d'interface conductrice (1 ; 11) étant un corps présentant une surface conductrice supérieure (2a ; 12a) en contact avec la zone de détection de toucher, une surface conductrice inférieure (2c ; 12c) en contact avec la zone conductrice de mesure (6), et un élément conducteur (2b, 2d ; 12b, 12d) de l'électricité s'étendant entre les surfaces conductrices supérieure (2a ; 12a) et inférieure (2c ; 12c) pour assurer une conduction électrique entre celles-ci, **caractérisé par le fait que** la pièce d'interface conductrice (1 ; 11) présente en outre au moins une surface non conductrice (3) s'étendant entre les surfaces conductrices supérieure (2a ; 12a) et inférieure (2c ; 12c), l'élément conducteur étant constitué par deux surfaces intermédiaires conductrices planes parallèles (2b, 2d ; 12b, 12d) entre elles et orthogonales aux plans du panneau de commande isolant (4) et de la carte électronique (5) et reliant de manière conductrice la surface conductrice supérieure (2a ; 12a) et la surface conductrice inférieure (2c ; 12c), les surfaces conductrices supérieure (2a ; 12a) et inférieure (2c ; 12c) étant situées entre les deux surfaces conductrices intermédiaires (2b, 2d ; 12b, 12d) de telle sorte que la pièce d'interface conductrice (1, 11) a sensiblement un profil de forme rectangulaire en coupe transversale.

2. Système selon la revendication 1, **caractérisé par le fait que** les surfaces non conductrices sont constituées par les surfaces externes vides entre les surfaces conductrices supérieure (12a), inférieure (12c) et intermédiaires (12b, 12d).

3. Système selon la revendication 1, **caractérisé par le fait que** la pièce d'interface conductrice (1) comporte en outre une mousse électriquement isolante (3) occupant l'espace entre les quatre faces conductrices (2a, 2b, 2c, 2d), les faces externes de la mousse électriquement isolante (3) orthogonales aux surfaces intermédiaires conductrices (2b, 2d) constituant deux surfaces non conductrices.

4. Système selon l'une des revendications 1 à 3, **caractérisé par le fait que** la mousse électriquement isolante (3) est en uréthane.

5. Système selon l'une des revendications 1 à 4, **caractérisé par le fait que** les surfaces conductrices sont en tresse métallique.

6. Système selon l'une des revendications 1 à 5, **caractérisé par le fait que** les surfaces conductrices intermédiaires de deux pièces d'interface conductrices adjacentes sont orthogonales.

## Patentansprüche

1. Berührungsdetektionssystem durch kapazitiven Effekt für elektronische Vorrichtung, das eine isolierende Bedientafel (4) mit mindestens zwei Berührungsdetektionsbereichen umfasst, eine elektronische Karte (5), die von der isolierenden Bedientafel (4) gesteuert wird und die elektronische Vorrichtung steuert, wobei die elektronische Karte (5) mindestens zwei leitende Messbereiche (6) umfasst, deren Veränderung der Kapazität von der elektronischen Karte (5) gemessen wird, wobei die isolierende Bedientafel (4) und die elektronische Karte (5) voneinander beabstandet und im wesentlichen parallel zueinander montiert sind, so dass jeder Berührungsdetektionsbereich der isolierenden Bedientafel (4) sich gegenüber einem leitenden Messbereich (6) befindet, wobei das Berührungsdetektionssystem zusätzlich eine leitende Schnittstelle (1; 11) zwischen jedem Berührungsdetektionsbereich und dem entsprechenden gegenüber letzterem gelegenen leitenden Messbereich (6) umfasst, wobei jedes leitende Schnittstellenelement (1; 11) ein Körper mit einer oberen leitenden Oberfläche (2a; 12a) ist, die in Kontakt mit dem Berührungsdetektionsbereich steht, einer unteren leitenden Oberfläche (2c; 12c), die in Kontakt mit dem leitenden Messbereich (6) steht, und einem leitenden Element (2b, 2d; 12b, 12d), das sich zwischen der oberen (2a; 12a) und der unteren leitenden Oberfläche (2c; 12c) erstreckt, um eine elektrische Leitung zwischen diesen zu sichern, **gekennzeichnet dadurch, dass** das leitende Schnittstellenelement (1; 11) außerdem mindestens eine nicht leitende Oberfläche (3) aufweist, die sich zwischen der oberen (2a; 12a) und der unteren leitenden Oberfläche (2c; 12c) erstreckt, wobei das leitende Element aus zwei ebenen zueinander parallelen leitenden Zwischenoberflächen (2b, 2d; 12b, 12d) besteht, die orthogonal zu den Ebenen der isolierenden Bedientafel (4) und der elektronische Karte (5) sind und auf leitende Art die obere leitende Oberfläche (2a; 12a) und die untere leitende Oberfläche (2c; 12c) verbinden, wobei die obere (2a; 12a) und die untere leitende Oberfläche (2c; 12c) zwischen den beiden leitenden Zwischenoberflächen (2b, 2d; 12b, 12d) liegen, so dass das leitende Schnittstellenelement (1, 11) im Querschnitt im wesentlichen rechteckig ist.

2. System nach Anspruch 1, **gekennzeichnet dadurch, dass** die nicht leitenden Oberflächen aus den leeren äußeren Oberflächen zwischen der leitenden oberen (12a), unteren (12c) und Zwischen-Oberfläche (12b, 12d) bestehen.

3. System nach Anspruch 1, **gekennzeichnet dadurch, dass** das leitende Schnittstellenelement (1) außerdem einen elektrisch isolierenden Schaumstoff (3) umfasst, der den Raum zwischen den vier leitenden Seiten (2a, 2b, 2c, 2d) einnimmt, wobei die äußeren Seiten des elektrisch isolierenden Schaumstoffs (3), die orthogonal zu den leitenden Zwischenoberflächen (2b, 2d) sind, zwei nicht leitende Oberflächen bilden.

4. System nach einem der Ansprüche 1 bis 3, **gekennzeichnet dadurch, dass** der elektrisch isolierende Schaumstoff (3) aus Urethan ist.

5. System nach einem der Ansprüche 1 bis 4, **gekennzeichnet dadurch, dass** die leitenden Oberflächen aus Metallgeflecht sind.

6. System nach einem der Ansprüche 1 bis 5, **gekennzeichnet dadurch, dass** die leitenden Zwischenoberflächen zweier angrenzender leitender Schnittstellenelemente orthogonal sind.

## Claims

1. A system for capacitive touch detection for an electronic device, comprising an insulating control panel (4) having at least two touch detection regions, an electronic card (5) controlled by the insulating control panel (4) and controlling the electronic device, the electronic card (5) having at least two measurement conducting regions (6) whose variation in capacity is measured by said electronic card (5), the insulating control panel (4) and the electronic card (5) being mounted spaced apart and substantially parallel such that each touch detection region of the insulating control panel (4) is facing a measurement conducting region (6), the touch detection system further comprising a conducting interface part (1; 11) between each touch detection region and the corresponding measurement conducting region (6) arranged facing said touch detection region, each conducting interface part (1; 11) being a body having an upper conducting surface (2a; 12a) in contact with the touch detection region, a lower conducting surface (2c; 12c) in contact with the measurement conducting region (6), and an electrically conducting member (2b, 2d; 12b, 12d) extending between the upper (2a; 12a) and lower (2c; 12c) conducting surfaces to ensure an electrical conduction therebetween, **characterized in that** the conducting interface part (1; 11) further has at least one non-conducting surface (3) extending between the upper (2a; 12a) and lower (2c; 12c) conducting surfaces, the conducting member being constituted by two plane conducting intermediate surfaces (2b ,2d; 12b, 12d) parallel therebetween and orthogonal to the planes of the insulating control panel (4) and of the electronic card (5) and conductively connecting the upper conducting surface (2a; 12a) and the lower conducting surface (2c; 12c), the upper (2a; 12a) and lower (2c; 12c) conducting surfaces being arranged between both intermediate conducting surfaces (2b, 2d; 12b, 12d) such that the conducting interface part (1, 11) substantially has a rectangular profile in cross-section.

2. The system according to claim 1, **characterized in that** the non-conducting surfaces are constituted by the empty external surfaces between the upper (12a), lower (12c) and intermediate (12b, 12d) conducting surfaces.

3. The system according to claim 1, **characterized in that** the conducting interface part (1) further comprises an electrically insulating foam (3) occupying the space between the four conducting faces (2a, 2b, 2c, 2d), the external faces of the electrically insulating foam (3) being orthogonal to the intermediate conducting surfaces (2b, 2d) constituting two non-conducting surfaces.

4. The system according to one of claims 1 to 3, **characterized in that** the electrically insulating foam (3) is made of urethane.

5. The system according to one of claims 1 to 4, **characterized in that** the conducting surfaces are made of metal braid.

6. The system according to one of claims 1 to 5, **characterized in that** the intermediate conducting surfaces of two adjacent conducting interface parts are orthogonal.
